# EUROPÄISCHE PATENTSCHRIFT

(11) **EP 1 118 259 B1**
(45) Veröffentlichungstag und Bekanntmachung des Hinweises auf die Patenterteilung: **19.01.2005**
(21) Anmeldenummer: 00953167.4
(22) Anmeldetag: 11.08.2000
(51) Int. Cl.: H05K 13/04, H01L 21/00

(54) **MONTAGEVORRICHTUNG**
ASSEMBLY DEVICE
DISPOSITIF DE MONTAGE

(30) Priorität: 11.08.1999 EP 99115834
(43) Veröffentlichungstag der Anmeldung: 25.07.2001
(73) Patentinhaber: Micromont Entwicklungs- und Handels GmbH, 8010 Graz (AT); Osram Opto Semiconductors GmbH & Co. OHG, 93049 Regensburg (DE)
(72) Erfinder: FERARIC, Johann, D-85579 Neubiberg (DE); WAITL, Günter, D-93049 Regensburg (DE)
(74) Vertreter: Hofstetter, Alfons J., Dr.rer.nat.
(86) Internationale Anmeldenummer: PCT/EP2000/007838
(87) Internationale Veröffentlichungsnummer: WO 2001/013697

(56) Entgegenhaltungen:
- WO-A-98/32160
- US-A- 5 040 291
- US-A- 5 840 594

## Beschreibung

Die vorliegende Erfindung betrifft eine Montagevorrichtung, insbesondere eine vollautomatische Montagevorrichtung zur Herstellung mikrosystemtechnischer Produkte sowie für Montageaufgaben in der Halbleiterindustrie, mit einem Montagetisch, mindestens einem Materialtransportsystem zum Transport der mit Bauteilen zu bestückenden Produkte, mindestens einem auf dem Montagetisch angeordnetem Transportsystem sowie mindestens eine bewegbare Bauteiltransporteinheit mit mindestens einem Montagekopf. Die vorliegende Erfindung betrifft zudem ein Verfahren zur Montage und Herstellung mikrosystemtechnischer Produkte.

Derartige Montagevorrichtungen sind aus dem Stand der Technik bekannt. Bekannte gattungsgemäße Montagevorrichtungen lassen sich in drei Hauptkategorien einteilen: Bestücker zur Herstellung von Elektronikkomponenten, Montageautomaten für die Halbleiterindustrie und Laborgeräte für die Montage von Mustern mikrosystemtechnischer Demonstratoren. Derartige Montagevorrichtungen weisen aber vielfältige Nachteile insbesondere für die Herstellung von Mikrosystemen auf.

So besteht bei der Produktion von Funktionsbaugruppen auf Basis von mikrosystemtechnischen Bauteilen zunehmend die Notwendigkeit, nur Bauteile nahezu gleicher Qualität für eine bestimmte Produktionscharge zu verwenden.

Beispielsweise wird bei der Produktion von auf LED's basierenden Beleuchtungskörpern zunehmend darauf geachtet, daß nur diejenigen LED's zusammen verarbeitet werden, welche im gleichen Frequenzspektrum und mit der gleichen Intensität Licht emittieren. Damit soll sicher gestellt werden, daß beim späteren Einsatz in Produkten keine auffälligen Unterschiede zwischen den einzelnen, benachbarten und verpackten LED's vorkommen. Problematisch dabei ist, daß bereits auf einem einzelnen Wafer als Standard-Anlieferungsform der LED's diese in verschiedenen Bandbreiten Licht emittieren, so daß selbst LED's eines Wafers nicht die gleichen charakteristischen Merkmale aufweisen.

Bei der bisherigen Produktion von auf LED's basierenden Beleuchtungskörpern werden diese in der Regel vom Wafer von sogenannten Die-Bondern vereinzelt und in spezifische Gehäuse montiert. Die-Bonder verarbeiten sequentiell die LED-tragenden Wafer, ohne daß die Unterschiede in der physikalischen Charakteristik der einzelnen LED's berücksichtigt werden. Bisherige Die-Bonder verarbeiten zudem nur einzelne Bänder, die entweder einoder mehrspurig die Gehäuse der LED's tragen. Durch diese Verarbeitungsform werden LED's auf ein Band gesetzt, welche unter Umständen sehr unterschiedliche Eigenschaften aufweisen. Die Folgen sind Qualitätssprünge auf dem einzelnen Band. Um diese Qualitätsunterschiede zu vermeiden und gleichzeitig konventionell arbeitende Die-Bonder bei der Montage einsetzen zu können, werden zunehmend Sortiermaschinen zum Einsatz gebracht. Diese haben die Aufgabe, vom einzelnen Wafer die bezüglich ihrer Eigenschaften identischen LED's abzunehmen und auf einen Zwischenträger, z.B. einem Kunstwafer, aufzutragen. Um den Sortiervorgang zu bewerkstelligen, werden Grundinformationen benötigt, welche die Informationen bezüglich der Eigenschaften der verschiedenen Einzel-LED's enthalten. Diese Grundinformationen können z.B. als "Wafer-Maps" bereit gestellt werden, wenn Bauteile der Halbleiterindustrie wie LED's verarbeitet werden. Grundinfonnationen können aber in jedem beliebigen Format vorliegen oder in beliebiger Art und Weise bereit gestellt werden. So werden z.B. LED's mit identischen Eigenschaften lokalisiert. Um diese "Wafer-Maps" zu erzeugen, werden außerhalb der Sortiermaschinen die einzelnen Wafer vermessen und die Messwerte elektronisch gespeichert. Nachdem die Sortiermaschine einen Wafer abgearbeitet hat, wird ein neuer eingespannt. Diese Sortierung setzt sich solange fort, bis der erste Zwischenträger bzw. Kunstwafer gefüllt ist und dieser gegen einen neuen, noch nicht besetzten Zwischenträger bzw. Kunstwafer ausgetauscht wird. Nachdem eine ausreichende Zahl von Zwischenträgem bzw. Kunstwafer mit LED's jeweils gleicher Klasse (Qualität) vorliegen, beginnt die oben beschriebene Verarbeitung in einem Die-Bonder. Die LED's werden vom Zwischenträgem bzw. Kunstwafer vereinzelt und auf eine einzelnes Band montiert. Durch die Vorsortierung gelangen nur LED's gleicher Qualität auf ein Band. Dabei ist jedoch nachteilig, daß zur Verarbeitung einer neuen Qualitätsklasse von LED's sowohl der jeweilige Kunstwafer als auch das zugehörige Band auf dem Die-Bonder ausgetauscht werden müssen. Durch eine derartige Verarbeitung mittels separater Vorsortierung wird zwar das prinzipielle Problem gelöst, nur LED's einer Klasse auf einem Band zu montieren. Nachteilig ist jedoch, dass eine separate Sortiermaschine benötigt wird, welche relativ teuer ist und langsam arbeitet. Zudem ist ein Materialhandling zwischen zwei verschiedenen Maschinentypen notwendig, nämlich der Sortiermaschine und dem nachgeschalteten Die-Bonder. Weiterhin muss die Zuordnung zwischen Wafer, Zwischenträger bzw. Kunstwafer und Band vom Operator getroffen werden. Mit steigender Zahl der Qualitätsklassen steigt damit auch die Verwechslungsgefahr. Schließlich sind verschiedene Materialaufspannung zu tätigen: Auf der Sortiermaschine die verschiedenen Wafer und die verschiedenen Zwischenträger und auf dem Die-Bonder die Zwischenträger und die Bänder. Diese Notwendigkeit verlangsamt den Produktionsfluss. Ein weiterer Nachteil ist, daß insbesondere für die Zwischenträger zusätzliche Trägermaterialien verwendet werden. Im Sinne der Ökologie stellt dies eine zusätzliche Belastung der Umwelt dar.

Eine Montagevorrichtung, die alle im ersten Teil des Anspruchs 1 genannten Merkmale aufweist, ist aus US-A-5 840 594 bekannt.

Die heute in der Halbleiterindustrie verwendeten Die-Bonder genügen den Anforderungen einer qualitätsorientierten Montage bzw. Montage und Sortierung in einem Arbeitsgang nicht. Die bekannten Die-Bonder-Ausführungen bieten aufgrund ihres Grundaufbaues kein ausreichendes Platzangebot, so daß z.B. mehrere getrennt angetriebene Materialtransporteinheiten eingesetzt werden könnten. Insbesondere ist der Grundaufbau dieser Die-Bonder so gewählt, daß eine ausreichende Montagepräzision in Kombination mit der hohen Montagegeschwindigkeit, in Kombination mit einer verfügbaren Platzangebot und einer damit einhergehenden Flexibilität durch freie Konfigwierbarkeit nicht möglich ist.

Es ist daher die Aufgabe der vorliegenden Erfindung, eine gattungsgemäße Montagevorrichtung bereitzustellen, welche die Montage und Sortierung von mikrosystemtechnischen Bauteilen in einem Arbeitsgang mit hoher Produktivität und Montagepräzision ermöglicht.

Gelöst wird diese Aufgabe durch eine Montagevorrichtung mit den Merkmalen gemäß dem Anspruch 1.

Vorteilhafte Ausgestaltungen sind in den Unteransprüchen beschrieben.

Bei einer erfindungsgemäßen Montagevorrichtung ist eine Bauteiltransporteinheit beziehungsweise -einheiten auf einem oder mehreren, mittels eines Transportsystems parallel zur Richtung des Transports der mittels des Materialtransportsystems bewegbaren und mit Bauteilen zu bestückenden Produkte verfahrbaren Trägersystem bzw. ―systemen angeordnet und das Materialtransportsystem besteht aus mindestens zwei parallel zueinander verlaufenden Einzeltransportsystemen, wobei jedes Einzeltransportsystem mit getrennt voneinander anzusteuernden Antriebssystemen versehen ist und zudem die Montagevorrichtung mindestens einen Informationsspeicher zur Aufnahme und Verarbeitung von bauteilspezifischen Daten einer Vielzahl von Bauteilen in einem Bauteilreservoir und von Daten bezüglich deren Lage innerhalb des Bauteilreservoirs aufweist, wobei die Steuerung der Bauteiltransporteinheit bzw. -einheiten und/oder des Montagetischs mit Hilfe dieser Daten erfolgt.

Durch die erfindungsgemäße Anordnung von Trägersystem und Materialtransportsystem ist es möglich, für den Bauteiltransport überwiegend nur den Montagekopf und/oder den Montagetisch zu bewegen. Das Trägersystem selbst führt dabei in bestimmten Montage-Modi nur eine kurze Ausgleichsbewegung durch, so daß relativ geringe Massen zu bewegen sind. Dadurch kann der Montagekopf mit größerer Geschwindigkeit bewegt werden, was wiederum zu größeren Durchsätzen und einer höheren Montagepräzision führt. Weiterhin ist es möglich, größere Transportbewegungen durch Verfahren der Trägersysteme durchzuführen, so daß die gesamte zur Verfügung stehende Oberfläche des Montagetisches abgefahren werden kann, und somit eine hohe Bauteil- und Substratvariation ermöglicht wird. Des weiteren wird es durch das oder die senkrecht zur Materialtransportrichtung angeordneten und parallel zu dieser verfahrbaren Trägersysteme möglich, dass sehr breite Materialen bzw. zu bestückende Produkte verarbeitet werden können. Vorteilhafterweise können gleichzeitig mehrals zwei Einzeltransportsysteme in der Montagevorrichtung angeordnet sein, so daß die Bestückungsgeschwindigkeit und die Bestückungsvariation deutlich erhöht wird. Entsprechend der vorliegenden bauteilspezifischen Informationen erfolgt die Montage des Bauteils auf das dazu korrespondierende Einzeltransportsystem mit dem entsprechenden zu bestückendem Produkt. Vorteilhafterweise entfällt bei dem erfindungsgemäßen System die Notwendigkeit einer separaten, teueren Sortiermaschine. Zudem erfolgt die Verarbeitung auf einer Maschine, so daß das Materialhandling zwischen Maschinen verschiedenen Typs entfällt. Schließlich wird die Zuordnung Bauteil / Einzeltransportsystem bzw. Produkt automatisch getroffen. Des weiteren entfällt vorteilhafterweise eine Vielzahl von Materialaufspannungen, so daß das Produktionsergebnis sich deutlich verbessert. Auch entfallen notwendige zusätzliche Trägermaterialien, da ohne Zwischenträger gearbeitet wird. Durch den portalartigen Aufbau bleibt zudem das Platzangebot auf dem Montagetisch erhalten, was für die Zugänglichkeit, Umrüstbarkeit und freie Konfigurierbarkeit vorteilhaft ist.

In einer vorteilhaften Ausgestaltung der erfindungsgemäßen Montagevorrichtung ist das Bauteilreservoir verfahrbar ausgebildet. Dadurch kann sich die Zuordnungsgeschwindigkeit der einzelnen Bauteile des Bauteilreservoirs zu einer bestimmten Abgabeposition deutlich erhöhen. Es wäre sogar denkbar, daß nur noch das Bauteilreservoir bewegt wird und das oder die Trägersysteme unbewegt bleiben.

In einer vorteilhaften Ausgestaltung der erfindungsgemäßen Montagevorrichtung besteht das Transportsystem aus einer in einem Maschinengestell der Montagevorrichtung parallel zur Richtung des Transports der mittels des oder der Materialtransportsysteme bewegbaren, mit den Bauteilen zu bestückenden Produkte angeordneten Schiene, wobei mindestens ein Trägersystemträger senkrecht in die Schiene eingreift, so daß das oder die Trägersysteme verfahrbar sind. Dadurch werden Reaktionskräfte aus der Bewegung der Bauteiltransporteinheit optimiert abgeleitet. Entstehende Vibrationen werden durch den verbesserten Kraftfluss minimiert.

In einer weiteren vorteilhaften Ausgestaltung der Erfindung weist das Trägersystem bzw. der Träger an dem der dritten Schiene gegenüberliegenden Ende ein Auflager auf, wobei das Auflager auf einem im Maschinengestell ausgebildeten und zur dritten Schiene parallel angeordneten Gegenlager zu liegen kommt. Dadurch wird das Platzangebot auf der Montageebene nochmals erweitert. Zudem steigt die Zugänglichkeit der Montagevorrichtung und deren freie Konfigurierbarkeit.

In einer weiteren vorteilhaften Ausgestaltung der erfindungsgemäßen Montagevorrichtung sind die Bewegungen mehrerer Trägersysteme untereinander synchronisierbar. Dadurch ist es möglich, die Produktionsgeschwindigkeit deutlich zu steigern. Durch eine dynamisch optimierte Synchronisierung mehrerer Trägersysteme in ihren jeweiligen Bewegungen kann eine deutliche Reduzierung der Maschinenschwingungen erreicht werden (dynamisches Wuchten), wodurch die Monategenauigkeit weiter gesteigert werden kann.

In einer weiteren vorteilhaften Ausgestaltung der Erfindung ist es auch möglich, daß mehrere Trägersysteme übereinander angeordnet sind. Eine derartige Anordnung erhöht die Anzahl der Montageebenen, was wiederum zu einer Erhöhung der Produktionsgeschwindigkeit und zu einer noch größeren Flexibilität in bezug auf die Anwendungsbereiche der erfindungsgemäßen Montagevorrichtung führt.

Die Erfindung betrifft weiterhin ein Verfahren zur Montage und Herstellung mikrosystemtechnischer Produkte unter Verwendung einer erfindungsgemäßen Montagevorrichtung, wobei das Verfahren folgende Schritte umfasst: (a) Aufnahme und Verarbeitung von bauteilspezifischen Daten einer Vielzahl von Bauteilen in einem Bauteilreservoir und von Daten bezüglich deren Lage innerhalb des Bauteilreservoirs in einem Informationsspeicher der Montagevorrichtung und (b) Steuerung einer Bauteiltransporteinheit bzw. mehrerer Bauteiltransporteinheiten und/oder eines Montagetischs der Montagevorrichtung mit Hilfe dieser Daten, derart, daß die Bauteile gemäß der statistischen Verteilung ihrer bauteilspezifischen Daten aufgenommen und verarbeitet werden. Zum Beispiel können Bauteile mit am häufigsten vorkommenden und vergleichbaren bauteilspezifischen Daten aus dem Bauteilreservoir entnommen werden und auf ein dem Bauteilreservoir am nächsten gelegenen Einzeltransportsystem eines Materialtransportsystems gelegt bzw. montiert werden. Dadurch ergibt sich vorteilhafterweise eine deutliche Mengenzeitoptimierung und somit eine Erhöhung der Bestückungsgeschwindigkeit.

Die Erfindung betrifft auch ein Verfahren zur Montage von LED-Chips auf Leadframe-Bänder unter Verwendung einer Ausführungsform der erfindungsgemäßen Montagevorrichtung, wobei LED-Chips nacheinander unter Zugrundelegung der im Informationsspeicher gespeicherten Daten von der Bauteiltransporteinheit von dem Wafer bzw. dem Epitaxiewafer entnommen werden und entsprechend ihrer bauteilspezifischen Daten auf eines von mehreren auf dem Montagetisch nebeneinander verlaufenden Leadframe-Bändern gesetzt werden, derart, daß Leadframe-Bänder mit LED-Chips erzeugt werden, die hinsichtlich ihrer bauteilspezifischen Daten derselben Bauteilgruppe angehören. Auch hierbei können zunächst LED-Chips mit am häufigsten vorkommenden und vergleichbaren bauteilspezifischen Daten aus dem Epitaxiewafer entnommen werden und auf ein dem Epitaxiewafer am nächsten gelegenen Leadframe-Band eines Leadframe-Transportsystems gelegt bzw. montiert werden.

Weitere Einzelheiten, Merkmale und Vorteile der Erfindung ergeben sich aus der folgenden Beschreibung eines zeichnerisch dargestellten Ausführungsbeispiels.

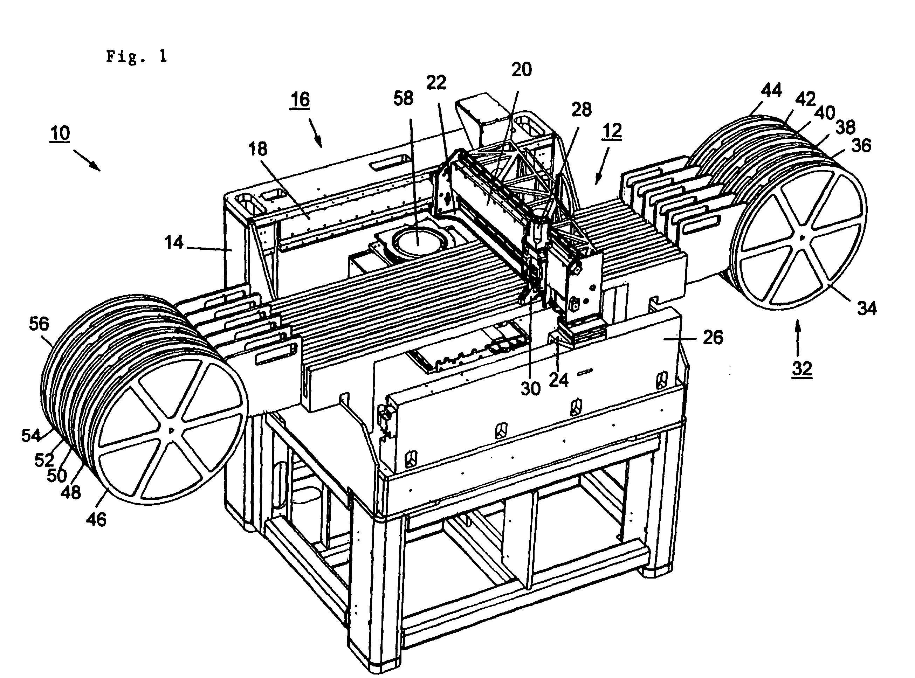

Die Figur zeigt eine Montagevorrichtung 10, insbesondere zur Verwendung als vollautomatische Montagevorrichtung zur Herstellung mikrosystemtechnischer Produkte sowie die Ausführung von Montageaufgaben in der Halbleiterindustrie. Die Montagevorrichtung 10 weist einen Montagetisch 12 auf. Auf dem Montagetisch 12 ist ein Transportsystem 16 angeordnet. Das Transportsystem 16 besteht aus einer in einem Maschinengestell 14 der Montagevorrichtung 10 parallel zur Richtung des Transports der mittels eines Materialtransportsystems 32 bewegbaren, mit den Bauteilen zu bestückenden Produkte angeordneten Schiene 18, wobei ein Trägersystemträger 22 eines Trägersystems 20 senkrecht in die Schiene 18 eingreift, so daß das Trägersystem 20 verfahrbar ist. Das Trägersystem 20 bzw. der Träger 22 weisen dabei an dem der Schiene 18 gegenüberliegenden Ende ein Auflager 24 auf, welches auf einem im Maschinengestell 14 ausgebildeten und zur Schiene 18 parallel angeordneten Gegenlager 26 zu liegen kommt. In einer weiteren, nicht dargestellten Ausführungsform kann auf das genannte Gegenlager verzichtet werden. Das Transportsystem 16 weist zudem einen Trägersystemantrieb (nicht dargestellt) auf.

Des weiteren ist es möglich, daß die Bewegungen mehrerer Trägersysteme untereinander synchronisierbar und mehrere Trägersysteme übereinander angeordnet sind (nicht dargestellt). Die Bewegungen mehrerer Trägersysteme können dabei derart koordiniert sein, daß unterschiedliche Montagehandlungen in vorbestimmter Reihenfolge durchgeführt werden.

Der Trägersystemträger 22 weist in seiner Längsrichtung eine längliche Eingriffsöffnung auf, in die eine Bauteiltransporteinheit 28 eingreift und bewegbar geführt ist. An der Bauteiltransporteinheit 28 ist ein Montagekopf 30 beweglich und lösbar befestigt.

In dem dargestellten Ausführungsbeispiel werden als Bauteile LED's bzw. LED-Chips verwendet, die zu LED-basierten Beleuchtungskörper verarbeitet werden.

Man erkennt, daß das Trägersystem 20 parallel zur Richtung des Materialtransports verfahrbar ist. Der Material- bzw. Produkttransport erfolgt mit Hilfe eines Materialtransportsystems 38, das ebenfalls im Bereich der Montage- beziehungsweise Tischebene angeordnet ist. Des weiteren wird deutlich, daß das Materialtransportsystem 32 aus mehreren parallel zueinander verlaufenden Einzeltransportsystemen 34, 36, 38, 40, 42, 44 besteht, wobei jedes Einzeltransportsystem 34, 36, 38, 40, 42, 44 mit getrennt voneinander anzusteuernden Antriebssystemen 46, 48, 50, 52, 54, 56 versehen ist. In dem Ausführungsbeispiel ist das Materialtransportsystem 32 ein Band-Transportsystem mit mehreren parallel zueinander angeordneten Einzelbändem. Das Band-Transportsystem kann z.B. ein Leadframe-Transportsystem sein.

Zudem weist die Montagevorrichtung 10 mindestens einen Informationsspeicher (nicht dargestellt) zur Aufnahme und Verarbeitung von bauteilspezifischen Daten einer Vielzahl von Bauteilen in einem Bauteilreservoir 58 und von Daten bezüglich deren Lage innerhalb des Bauteilreservoirs 58 auf, wobei die Steuerung der Bauteiltransporteinheit bzw. ―einheiten 28 mit Hilfe dieser Daten erfolgt. Das Bauteilreservoir 58 besteht dabei aus einem Wafer. Bei den in dem Informationsspeicher aufgenommenen und verarbeiteten Daten handelt es sich um sogenannte "Wafer-Maps", in denen die bauteilspezifischen Daten jedes einzelnen Bauteils bzw. LED-Chips und die jeweils zugehörige Position des Bauteils bzw. LED-Chips auf dem Wafer enthalten sind.

Der Wafer kann zudem einen separierten Epitaxiewafer aufweisen, in dem die Position der einzelnen LED-Chips seit der Epitaxie-Abscheidung einer LED-Schichtenfolge und deren Separierung in einzelne LED-Chips unverändert ist.

## Patentansprüche

1. Montagevorrichtung, insbesondere vollautomatische Montagevorrichtung zur Herstellung mikrosystemtechnischer Produkte sowie für Montageaufgaben in der Halbleiterindustrie, mit einem Montagetisch (12), einem Materialtransportsystem (32) zum Transport der mit Bauteilen zu bestückenden Produkte, mindestens einem auf dem Montagetisch (12) angeordnetem Transportsystem (16) sowie mindestens eine bewegbare Bauteiltransporteinheit (28) mit mindestens einem Montagekopf (30), wobei
die Bauteiltransporteinheit bzw. -einheiten (28) auf einem oder mehreren, mittels des Transportsystems (16) parallel zur Richtung des Transports der mittels des Materialtransportsystems (32) bewegbaren und mit den Bauteilen zu bestückenden Produkte verfahrbaren Trägersystem oder -systemen (20) angeordnet ist bzw. sind und die Montagevorrichtung (10) mindestens einen Informationsspeicher zur Aufnahme und Verarbeitung von bauteilspezifischen Daten einer Vielzahl von Bauteilen in mindestens einem Bauteilreservoir (58) und von Daten bezüglich deren Lage innerhalb des Bauteilreservoirs (58) aufweist, wobei die Steuerung der Bauteiltransporteinheit bzw. ―einheiten (28) und/oder des Montagetischs (12) einschließlich des darauf befestigten Materialtransportsystems (32) mit Hilfe dieser Daten erfolgt,
**dadurch gekennzeichnet,**
**daß** das Materialtransportsystem (32) aus mindestens zwei parallel zueinander verlaufenden Einzeltransportsystemen (34, 36, 38, 40, 42, 44) besteht, wobei jedes Einzeltransportsystem (34, 36, 38, 40, 42, 44) mit getrennt voneinander anzusteuernden Antriebssystemen (46, 48, 50, 52, 34, 56) versehen ist.

2. Montagevorrichtung nach Anspruch 1,
**dadurch gekennzeichnet,**
**daß** das Bauteilreservoir (58) verfahrbar ausgebildet ist.

3. Montagevorrichtung nach Anspruch 1 oder 2,
**dadurch gekennzeichnet,**
**daß** das Transportsystem (16) aus einer in einem Maschinengestell (14) der Montagevorrichtung (10) parallel zur Richtung des Transports der mittels des Materialtransportsystems (32) bewegbaren, mit den Bauteilen zu bestückenden Produkte angeordneten Schiene (18) besteht, wobei mindestens ein Träger (22) senkrecht in die Schiene (18) eingreift, so daß das oder die Trägersysteme (20) verfahrbar sind.

4. Montagevorrichtung nach Anspruch 3,
**dadurch gekennzeichnet,**
**daß** das Trägersystem (20) bzw. der Träger (22) an dem der Schiene (18) gegenüberliegenden Ende ein Auflager (24) aufweist, wobei das Auflager (24) auf einem im Maschinengestell (14) ausgebildeten und zur Schiene (18) parallel angeordneten Gegenlager (26) zu liegen kommt.

5. Montagevorrichtung nach einem der vorhergehenden Ansprüche,
**dadurch gekennzeichnet,**
**daß** das Transportsystem (16) mindestens einen Trägersystemantrieb aufweist.

6. Montagevorrichtung nach einem der vorhergehenden Ansprüche,
**dadurch gekennzeichnet,**
**daß** die Bewegungen mehrerer Trägersysteme untereinander synchronisierbar sind.

7. Montagevorrichtung nach einem der vorhergehenden Ansprüche,
**dadurch gekennzeichnet,**
**daß** mehrere Trägersysteme übereinander angeordnet sind.

8. Montagevorrichtung nach einem der vorhergehenden Ansprüche,
**dadurch gekennzeichnet,**
**daß** die Bauteile LED's bzw. LED-Chips und die zu bestückenden Produkte LEDbasierte Beleuchtungskörper sind.

9. Montagevorrichtung nach einem der vorhergehenden Ansprüche,
**dadurch gekennzeichnet,**
**daß** das Materialtransportsystem (32) ein Band-Transportsystem ist.

10. Montagevorrichtung nach Anspruch 9,
**dadurch gekennzeichnet,**
**daß** das Band-Transportsystem ein Leadframe-Transportsystem ist.

11. Montagevorrichtung nach einem der vorhergehenden Ansprüche,
**dadurch gekennzeichnet,**
**daß** das Bauteilreservoir (58) aus mindestens einem Wafer besteht.

12. Montagevorrichtung nach Anspruch 8 und 11,
**dadurch gekennzeichnet,**
**daß** der Wafer einen separierten Epitaxiewafer aufweist, in dem die Position der einzelnen LED-Chips seit der Epitaxie-Abscheidung einer LED-Schichtenfolge und deren Separierung in einzelne LED-Chips unverändert ist.

13. Montagevorrichtung nach Anspruch 11 oder12,
**dadurch gekennzeichnet,**
**daß** es sich bei den in dem Informationsspeicher aufgenommenen und verarbeiteten Daten um "Wafer-Maps" handelt, in denen die bauteilspezifischen Daten jedes einzelnen Bauteils bzw. LED-Chips und die jeweils zugehörige Position des Bauteils bzw. LED-Chips auf dem Wafer enthalten sind.

14. Verfahren zur Montage und Herstellung mikrosystemtechnischer Produkte unter Verwendung einer Montagevorrichtung gemäß Anspruch 1,
**dadurch gekennzeichnet,**
**daß** das Verfahren folgende Schritte umfasst:
a) Aufnahme und Verarbeitung von bauteilspezifischen Daten einer Vielzahl von Bauteilen in einem Bauteilreservoir (58) und von Daten bezüglich deren Lage innerhalb des Bauteilreservoirs (58) in einem Informationsspeicher der Montagevorrichtung (10); und
b) Steuerung einer Bauteiltransporteinheit bzw. mehrerer Bauteiltransport-einheiten (28) und/oder eines Montagetischs (12) der Montagevorrichtung (10) mit Hilfe dieser Daten, derart, daß die Bauteile gemäß der statistischen Verteilung ihrer bauteilspezifischen Daten aus dem Bauteilreservoir (58) entnommen und verarbeitet werden.

15. Verfahren nach Anspruch 14,
**dadurch gekennzeichnet,**
**daß** im Verfahrensschritt b) zunächst Bauteile mit am häufigsten vorkommenden und vergleichbaren bauteilspezifischen Daten aus dem Bauteilreservoir (58) entnommen werden und auf ein dem Bauteilreservoir (58) am nächsten gelegenen Einzeltransportsystem (44) eines Materialtransportsystems (32) gelegt bzw. montiert werden.

16. Verfahren zur Montage von LED-Chips auf Leadframe-Bänder unter Verwendung einer Montagevorrichtung gemäß Anspruch 12 oder 12 und 13,
**dadurch gekennzeichnet,**
**daß** die LED-Chips nacheinander unter Zugrundelegung der im Informationsspeicher gespeicherten Daten von der Bauteiltransporteinheit (28) von dem Wafer bzw. dem Epitaxiewafer entnommen werden und entsprechend ihrer bauteilspezifischen Daten auf eines von mehreren auf dem Montagetisch (12) nebeneinander verlaufenden Leadframe-Bändern gesetzt werden, derart, daß Leadframe-Bänder mit LED-Chips erzeugt werden, die hinsichtlich ihrer bauteilspezifischen Daten derselben Bauteilgruppe angehören.

17. Verfahren nach Anspruch 16,
**dadurch gekennzeichnet,**
**daß** zunächst LED-Chips mit am häufigsten vorkommenden und vergleichbaren bauteilspezifischen Daten aus dem Epitaxiewafer entnommen werden und auf ein dem Epitaxiewafer am nächsten gelegenen Leadfrarne-Band eines Leadframe-Transportsystems gelegt bzw. montiert werden.

## Claims

1. Assembling device, especially fully-automatic assembling device for producing micro-system-technical products as well as for assembling jobs in the semiconductor industry, including an assembling table (12), a material transfer system (32) for transferring the products to be loaded with components, at least one transfer system (16) disposed on the assembling table (12), as well as at least one movable component transfer unit (28) having at least one assembling head (30), wherein the component transfer unit or units (28), respectively, is or are disposed on one or more carrier system or systems (20), respectively, movable by means of the transfer system (16) parallel to the direction of transfer of the products movable by means of the material transfer system (32) and to be loaded with the components, and the assembling device (10) has at least one information memory for receiving and processing component-specific data of a plurality of components in at least one component reservoir (58) and data relating to the position thereof within the component reservoir (58), wherein the control of the component transfer unit or units (28), respectively, and/or of the assembling table (12) including the material transfer system (32) secured thereon is effected by means of these data, **characterized in that** the material transfer system (32) consists of at least two individual transfer systems (34, 36, 38, 40, 42, 44) extending parallel to each other, each individual transfer system (34, 36, 38, 40, 42, 44) being provided with driving systems (46, 48, 50, 52, 54, 56) to be driven separately from each other.

2. Assembling device according to claim 1,
**characterized in that**
the component reservoir (58) is formed in movable manner.

3. Assembling device according to claim 1 or 2,
**characterized in that**
the transfer system (16) is comprised of a rail (18) disposed in a machine rack (14) of the assembling device (10) parallel to the direction of transfer of the products movable by means of the material transfer system (32) and to be loaded with the components, wherein at least one carrier (22) engages the rail (18) perpendicularly, such that the carrier system(s) (20) is (are) movable.

4. Assembling device according to claim 3,
**characterized in that**
the carrier system (20) or the carrier (22), respectively, has a support (24) at the end opposing the rail (18), wherein the support (24) rests on an abutment (26) formed in the machine rack (14) and disposed parallel to the rail (18).

5. Assembling device according to any one of the preceding claims,
**characterized in that**
the transfer system (16) has at least one carrier system drive.

6. Assembling device according to any one of the preceding claims,
**characterized in that**
the movements of plural carrier systems are able to be synchronized with respect to each other.

7. Assembling device according to any one of the preceding claims,
**characterized in that**
plural carrier systems are disposed one above the other.

8. Assembling device according to any one of the preceding claims,
**characterized in that**
the components are LEDs or LED chips, respectively, and the products to be loaded are LED-based illuminators.

9. Assembling device according to any one of the preceding claims,
**characterized in that**
the material transfer system (32) is a belt transfer system.

10. Assembling device according to claim 9,
**characterized in that**
the belt transfer system is a leadframe transfer system.

11. Assembling device according to any one of the preceding claims,
**characterized in that**
the component reservoir (58) consists of at least one wafer.

12. Assembling device according to claim 8 and 11,
**characterized in that**
the wafer has a separated epitaxial wafer, in which the position of the individual LED chips since the epitaxial deposition of a LED layer sequence and separation thereof into individual LED chips is unchanged.

13. Assembling device according to claim 11 or 12,
**characterized in that**
the data received and processed in the information memory are "wafer maps", in which the component-specific data of each individual component or LED chip, respectively, and the respectively associated position of the component or LED chip on the wafer, respectively, are contained.

14. Method of assembling and producing micro-system-technical products using an assembling device according to claim 1,
**characterized in that**
the method includes the following steps:
a) receiving and processing component-specific data of a plurality of components in a component reservoir (58) and data relating to the position thereof within the component reservoir (58) in an information memory of the assembling device (10); and
b) controlling a component transfer unit or plural component transfer units (28), respectively, and/or an assembling table (12) of the assembling device (10) by means of these data such that the components are removed from the component reservoir (58) and processed according to the statistical distribution of their component-specific data.

15. Method according to claim 14,
**characterized in that**
in the method step b), first, components with most frequently occurring and comparable component-specific data are removed from the component reservoir (58) and are placed or mounted on an individual transfer system (44) of a material transfer system (32) closest to the component reservoir (58), respectively.

16. Method of assembling LED chips on leadframe belts using an assembling device according to claim 12 or 12 and 13,
**characterized in that**
the LED chips are successively removed by the component transfer unit (28) from the wafer or the epitaxial wafer, respectively, based upon the data stored in the information memory, and are placed on one of plural leadframe belts extending side-by-side on the assembling table (12) according to their component-specific data such that leadframe belts with LED chips are produced, which belong to the same component group with respect to their component-specific data.

17. Method according to claim 16,
**characterized in that**
first, LED chips with most frequently occurring and comparable component-specific data are removed from the epitaxial wafer and placed or mounted on a leadframe belt of a leadframe transfer system closest to the epitaxial wafer, respectively.

## Revendications

1. Dispositif de montage, notamment dispositif de montage à fonctionnement entièrement automatique, destiné à la fabrication de produits de technique de microsystèmes ainsi qu'au remplissement de fonctions de montage dans l'industrie des semi-conducteurs, comportant une table de montage (12), un système de transfert (32) des produits prévus d'être équipés de composants, au moins un système de transfert (16) disposé sur la table de montage (12) ainsi qu'au moins une unité de transfert (28) des composants (28) comprenant au moins une tête de montage (30), l'unité respectivement les unités de transfert des composants (28) étant disposée/s sur un ou plusieurs système/s de support (20) adapté/s pour être déplacé/s parallèlement à la direction de transfert des produits prévus d'être équipés des composants, grâce au système de transfert (16),
**caractérisée en ce**
**que** le système de transfert de produits (32) comporte au moins deux systèmes individuels de transfert (34, 36, 38, 40, 42, 44) s'étendant parallèlement l'un par rapport à l'autre, chacun des systèmes individuels de transfert (34, 36, 38, 40, 42, 44) étant équipé de mécanismes de commande (46, 48, 50, 52, 54, 56) à amorçage individuel, le dispositif de montage (10) comprenant au moins une mémoire de données prévue de recevoir et de traiter des données spécifiques aux composants d'une multitude de composants se trouvant dans au moins un réservoir de composants (58) et des données concernant leur position à l'intérieur du réservoir de composants (58), le pilotage de l'unité/des unités de transfert (28) des composants et/ou de la table de montage (12), y compris le système de transfert des produits (32) fixé sur celui-ci, ayant été assuré sur la base desdites données,

2. Dispositif de montage selon la revendication 1,
**caractérisé en ce**
**que** le réservoir des composants (58) est conçu sous forme mobile.

3. Dispositif de montage selon la revendication 1 ou 2,
**caractérisé en ce**
**que** le système de transfert (16) est prévu sous forme d'un rail (18) déplaçable à l'intérieur d'un bâti (14) du dispositif de montage (10) parallèlement à la direction de transfert des produits prévus d'être déplacés à l'aide du système de transfert de produits (32) et d'être équipés des composants, un support (22) au moins prenant verticalement dans le rail (18) de manière à permettre le déplacement du système ou des systèmes de support (20).

4. Dispositif de montage selon la revendication 3,
**caractérisé en ce**
**que** le système de support (20) respectivement le support (22) comporte, à l'extrémité opposée au rail (18), un appui (24), l'appui (24) venant s'appuyer sur un palier-support (26) constitué dans le bâti (14) et disposé parallèlement au rail (18).

5. Dispositif de montage selon l'une des revendications précédentes,
**caractérisé en ce**
**que** le système de transfert (16) comprend au moins un mécanisme d'entraînement du système de support.

6. Dispositif de montage selon l'une des revendications précédentes,
**caractérisé en ce**
**que** les mouvements de plusieurs systèmes de support sont aptes à être réglés en synchronisme l'un par rapport à l'autre.

7. Dispositif de montage selon l'une des revendications précédentes,
**caractérisé en ce**
**que** plusieurs systèmes de support sont disposés l'un au-dessus de l'autre.

8. Dispositif de montage selon l'une des revendications précédentes,
**caractérisé en ce**
**que** les composants sont des DEL respectivement des puces DEL et que les produits à équiper sont des luminaires à base de DEL.

9. Dispositif de montage selon l'une des revendications précédentes,
**caractérisé en ce**
**que** le système de transfert de produits (32) est un système de transfert à courroie.

10. Dispositif de montage selon la revendication 9,
**caractérisé en ce**
**que** le système de transfert à courroie est un système de transfert à conducteurs-poutre.

11. Dispositif de montage selon l'une des revendications précédentes,
**caractérisé en ce**
**que** le réservoir des composants (58) comporte au moins une pastille.

12. Dispositif de montage selon les revendications 8 et 11,
**caractérisé en ce**
**que** la pastille comporte une pastille épitaxiale séparée dans laquelle la position des différentes puces DEL est inchangée depuis l'épitaxie d'une suite de couches DEL et la séparation de celles-ci en puces DEL individuelles.

13. Dispositif de montage selon la revendication 11 ou 12,
**caractérisé en ce**
**que** quant aux données reprises et traitées dans la mémoire de données, il s'agit de "cartes pastilles" contenant les données spécifiques des composants individuels respectivement des puces DEL ainsi que la position correspondante du composant respectivement de la puce DEL sur la pastille.

14. Procédé de montage et de fabrication de produits de technique de microsystèmes mettant en oeuvre un dispositif de montage selon la revendication 1,
**caractérisé en ce**
**que** le procédé comprend les étapes suivantes:
a) reprise et traitement de données spécifiques d'une multitude de composants présents dans un réservoir de composants (58) et de données concernant leur position à l'intérieur du réservoir des composants (58) dans une mémoire de données du dispositif de montage (10); et
b) pilotage d'une unité de transfert de composants resp. de plusieurs unités de transfert de composants (28) et/ou d'une table de montage (12) du dispositif de montage (10) à l'aide de desdites données, de sorte que les composants soient repris depuis le réservoir de composants (58) et utilisés selon la répartition statistique de leurs données spécifiques.

15. Procédé selon la revendication 14,
**caractérisé en ce**
**que** dans l'étape b), ce sont d'abord les composants présentant des données spécifiques plus fréquemment rencontrées et comparables qui sont prélevés dans le réservoir des composants (58) pour être placés respectivement montés sur un système de transfert individuel de produits (44) se trouvant au plus près du réservoir des composants (58) d'un système de transfert de produits (32).

16. Procédé de montage de puces DEL sur des courroies conducteurs-poutre mettant en oeuvre un dispositif de montage selon la revendication 12 ou 12 et 13,
**caractérisé en ce**
**que** les puces DEL sont prélevées l'une après l'autre sur la base des données stockées dans la mémoire des données par l'unité de transfert des composants (28) depuis la pastille respectivement la pastille épitaxiale pour être placées, conformément à leurs données spécifiques relatives aux composants, sur une des courroies conducteur-poutre juxtaposées sur la table de montage (12) de manière à produire des courroies conducteur-poutre à puces DEL faisant partie, quant à leurs données spécifiques, du même groupe de composants.

17. Procédé selon la revendication 16,
**caractérisé en ce**
**que** ce sont d'abord les puces DEL présentant les données spécifiques relatives aux composants les plus fréquemment rencontrées et comparables qui sont prélevées dans la pastille épitaxiale pour être placées respectivement montées sur une courroie conducteur-poutre d'un système de transfert conducteur-poutre se trouvant le plus proche de la pastille épitaxiale.
